# EUROPEAN PATENT SPECIFICATION

(11) **EP 0 354 536 B1**
(45) Date of publication and mention of the grant of the patent: **23.04.1997**
(21) Application number: 89114657.3
(22) Date of filing: 08.08.1989
(51) Int. Cl.: G03F 7/38

(54) **Pattering method**
Bilderzeugungsverfahren
Procédé pour l'obtention d'images

(30) Priority: 09.08.1988 JP 197118/88; 09.08.1988 JP 197115/88; 30.09.1988 JP 243865/88
(43) Date of publication of application: 14.02.1990
(73) Proprietor: KABUSHIKI KAISHA TOSHIBA, Kawasaki-shi, Kanagawa-ken 210 (JP)
(72) Inventor: Ito, Shinichi, Yokohama-shi Kanagawa-ken (JP); Okano, Haruo, Ota-ku Tokyo (JP); Nakase, Makoto, Setagaya-ku Tokyo (JP)
(74) Representative: Hansen, Bernd, Dr.Dipl.-Chem.

(56) References cited:
- EP-A- 0 291 670
- DE-A- 3 541 451
- PATENT ABSTRACTS OF JAPAN, Vol. 8, No. 167 (E-258)(1604) 02 August 1984; & JP-A-59 061 928 (HITACHI SEISAKUSHO) 09 April 1984
- PATENT ABSTRACTS OF JAPAN, Vol. 7, No. 17 (E-154)(1162) 22 January 1983; & JP-A-56 059 216 (TOKYO SHIBAURA DENKI K.K.) 26 October 1982
- PATENT ABSTRACTS OF JAPAN, Vol. 7, No. 23 (P-171)(1168) 29 January 1983; & JP-A-57 176 040 (TOKYO SHIBAURA DENKI K.K.) 29 October 1982
- Microelectronic Engineering 5(1986) 291.297 North Holland F. Coopmans et al. "Effects of Silylation Parameters on the Lithographic performance of the DESIRE system"

## Description

### BACKGROUND OF THE INVENTION

### 1. Field of the Invention

The present invention relates to a method of patterning a resist during a lithography process in manufacturing a semiconductor device. Particularly, the invention relates to a patterning method employing a silylating process.

### 2. Description of the Prior Art

Recent semiconductor technologies have improved the speed and integration of semiconductor devices and elements. This has increased the necessity of minimizing patterns formed on the semiconductor devices and of improving accuracy of the patterns.

A prevalent lithography process employs a photosensitive polymer (resist) pattern as a mask to etch a base thin film according to a reactive ion etching (RIE) method. The resist pattern shall be formed accurately with high aspect ratio on the stepped surface of a semiconductor element. This requirement is hardly met with a monolayer process of optical lithography technique. This increases the importance of employing a multilayer resist method.

According to the multilayer resist method, multiple layers provide respective resist functions. Namely, a resist layer of 2 to 3µm in thickness is disposed on the surface of a semiconductor element to flatten steps formed on the surface of the element and absorb light reflected by a substrate of the element. On the resist layer, a high-resolution resist layer is disposed to form a pattern. Since the exposure and development of the pattern is carried out away from the substrate and under ideal conditions, the pattern will be of high resolution and have accurate dimensions.

The multilayer resist method is achieved in various ways depending on the number of layers and the techniques of transferring a pattern to lower layers.

A typical one of the multilayer methods is a three layer resist method which provides upper and lower resist layers and an intermediate resist layer disposed between the upper and lower resist layers. According to the three layer resist method, a pattern is transferred from the upper layer to the intermediate layer and from the intermediate layer to the lower layer with the use of a reactive ion etching (RIE) process. The intermediate layer prevents the upper and lower resist layers from interacting each other and provides pressure resistance for the lower resist layer when the lower layer is subjected to the RIE process. To achieve this function, the intermediate layer is usually made of SOG (spin on glass, i.e., organic silicon glass) formed according to a rotational coating method.

The three layer resist method is relatively stable compared to other methods. However, it involves complicated processes including two RIE processes so that the three layer resist method may not be practical to apply for mass production.

To simplify the processes, various techniques have been discussed. One of promising techniques is a silylating process. This process realizes the function of the three layer resist method only with monolayer resist. Therefore, the silylating process may be an ideal and ultimate resist process.

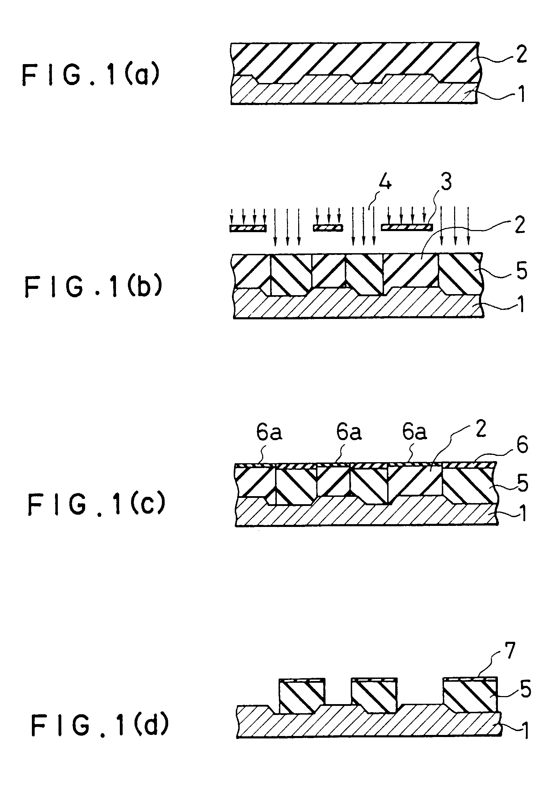

A Japanese Laid Open Patent Application No. 61-107346 discloses a typical silylating process. This process will be explained with reference to Figs. 1(a) to 1(d).

In Fig. 1(a), the surface of a substrate 1 is coated with a photosensitive resin layer 2, and a mask 3 is disposed on the resin layer 2. The resin layer 2 with the mask 3 on it is exposed against exposure rays 4 such as ultraviolet rays to form exposed portions 5 on the photosensitive resin layer 2, as shown in Fig. 1(b). Silicon compounds are applied to the exposed portions 5. The silicon compounds are selectively absorbed by the exposed portions 5 to form silylated layers 6 as shown in Fig. 1(c). Then, an etching process is carried out to remove non-exposed portions of the photosensitive resin layer 2 to form a pattern as shown in Fig. 1(d).

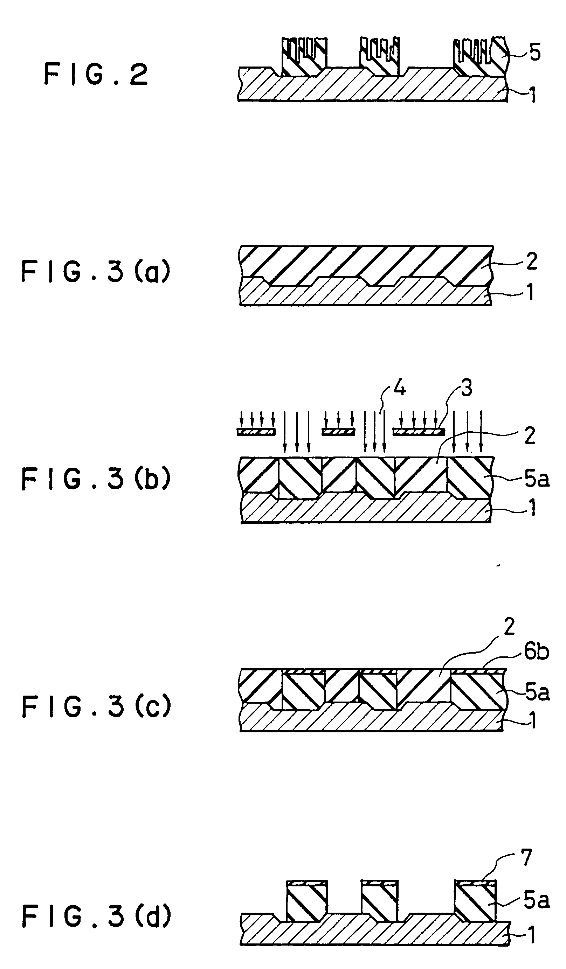

According to such a conventional silylating process, not only the exposed portions 5 but also the non-exposed portions are silylated to form silylated layers 6a. The layers 6a are minor if compared to the silylated layers 6, but the layers 6a deteriorate selectivity of the pattern. Therefore, the conventional silylating process is not practically applicable and, depending on conditions, it causes cracks as shown in Fig. 2.

The silylated layers 6a formed on the non-exposed portions, respectively, shall be removed. For this purpose, mixed gases such as gases of CF₄ and O₂ or gases of C₂F₆ and O₂ are used to etch the silylated layers 6a. However, when the silylated layers 6a on the non-exposed portions are etched with the mixed gases, the silylated layers 6 on the exposed portions are also etched. Since an etching speed of the exposed portions is higher than that of the non-exposed portions, the silylated layers 6 are etched more than the silylated layers 6a. Then, the pattern is not accurately formed. In addition, the reactive etching with oxygen may leave refuse.

DE 35 41 451 A1 discloses a process comprising selectively exposing a photosensitive resist layer and decomposing (by a treatment with alkali) the acid reaction products formed in the exposed parts of the quinonediazide resin, by the reaction of the photolytic ketene with the moisture in the air.

The article "Effects of Silylation Parameters on the Lithographic performance of the DESIRE System" from F. Coopmans et al in Microelectronic Engineering 5 (1986) 291-297 North-Holland describes a Diffusion Enhance Silylating Resist System as it is disclosed in the above-mentioned JP-61-107346 in more detail.

### SUMMARY OF THE INVENTION

It is the object of the present invention to improve the selectivity of silylation.

This object is solved by a method according to claim 1. The subclaims show further advantageous developments of the method of the invention.

A silylated film has to be formed on a prescribed exposed surface of a resist in correspondence with a desired pattern while the remaining unexposed surface should not be protected by the film in order to make it possible to selectively remove the resin. Ideally, silylation does not take place in the unexposed surface. The silylation, however, goes on to some extent even in the unexposed surface during the silylation process of the exposed surface. The present invention proposes to accelerate the silylation process of the exposed surface in order to relatively decrease the thickness of the silylated film of the unexposed surface, thus improving the selectivity of silylation.

According to an aspect of the invention, a photosensitive resin layer is treated with alkali before or after the photosensitive resin layer is exposed. Then, the photosensitive resin layer is silylated.

The photosensitive resin layer, i.e., a resist layer contains photoactive material that is diazo-quinone derivative. The diazo-quinone derivative becomes ketene when it is irradiated with light. The ketene reacts with water contained in air to become carboxylic acid. The carboxylic acid achieves hydrogen bond with a -OH radical of polymer contained in the photosensitive resin layer. Further, the carboxylic acid achieves dehydration and degeneracy reactions when heated, to become ester. The hydrogen bond and dehydration and degeneracy reactions prevent polymers from absorbing the silicon compounds as well as preventing the polymers from reacting with the silicon compounds.

In this way, if there is a large amount of carboxylic acid in the photosensitive resin layer, exposed portions of the layer are not satisfactorily selected with respect to non-exposed portions of the layer after the silanization, so that a good pattern may not be obtained.

The present invention utilizes the fact that the carboxylic acid causes a decarbonating reaction with alkali, and the invention treats the exposed portions of the photosensitive resin layer with the alkali to decompose the carboxylic acid contained in the photosensitive resin layer. As a result, silicon compounds are quickly absorbed by the photosensitive resin layer to provide a good pattern at high selectivity.

If the photosensitive resin layer is treated with alkali before the exposing process, the carboxylic acid and carboxylate are quickly decomposed by the alkali. Therefore, the silicon compounds are quickly absorbed by the photosensitive resin layer to improve selectivity and provide a good pattern. In addition, the basic treatment suppresses the absorption of silicon compounds by the non-exposed portions of the photosensitive resin layer, although the suppression is not so conspicuous.

Further, a layer to be silylated is subjected to ion etching with rare gases and then subjected to a reactive ion etching process with oxygen. The rare gases have no selectivity of elements so that exposed and non-exposed portions of the layer to be silylated are uniformly etched. As a result, losses of silylated layers formed on the exposed portions are minimized, and resistivity against the reactive ion etching process with oxygen is increased. Therefore, a pattern of high selectivity is formed on the exposed portions of the layer. By employing a magnetron system or an ECR system for the reactive ion etching process with oxygen, a pattern of no refuse may be obtained.

Further, an oxygen plasma process is carried out in a silylating process to harden a required pattern on a photosensitive resin layer. Then, an etching process such as reactive ion etching process is carried out to selectively form the required pattern on the layer. The oxygen plasma process is carried out before the reactive ion etching process of the silylating process such that a film of SiO₂ structure is formed on the surfaces of exposed portions of the photosensitive resin resist layer to suppress a decomposing reaction of the exposed portions during the reactive ion etching process that uses oxygen. As a result, a highly accurate pattern is formed on non-exposed portions of the resin layer. The exposed portions are covered with the film of SiO₂ structure formed according to the oxygen plasma process so that a speed of decomposing reaction of the exposed portions may be slower than that of the non-exposed portions whose surfaces are not covered with such a film. As a result, a pattern of high selectivity is formed on the resin layer.

### BRIEF DESCRIPTION OF THE DRAWINGS

Fig. 1(a) to 1(d) are sectional views showing a conventional patterning method;
Fig. 2 is a sectional view showing an example of patterns formed according to the conventional patterning method;
Figs. 3(a) to 3(d) are sectional views showing a patterning method according to the invention; and
Figs. 4(a) to 4(e) are sectional views showing another patterning method according to the invention.

### DETAILED DESCRIPTION OF THE EMBODIMENTS

Embodiments of the invention will now be described in detail with reference to the drawings.

### Embodiment 1

Figures 3(a) to 3(d) are views showing respective processes according to the first embodiment of the invention. In the figures, parts similar to those shown in Figs. 1(a) to 1(d) are represented with like reference numerals.

In Fig. 3(a), a silicon wafer 1 is coated with a photosensitive resin layer 2 with the use of a spin coat technique of 3500 rpm. The silicon wafer 1 and resin layer 2 are baked for five minutes at 90 °C to prepare a sample. Before coating the photosensitive resin layer 2 over the silicon wafer 1, the wafer 1 is exposed to an atmosphere of hexamethyldisilazane for 120 seconds to reform the surface of the wafer 1 to improve its adhesion.

To prepare the photosensitive resin layer 2, eight grams of novolak resin and two grams of photosensitive material containing photoactive naphthoquinonediazide are solved in twenty-three grams of ethylcellosolve-acetate and conditioned.

As shown in Fig. 3(b), masks 3 are disposed on the sample, and the sample is exposed to g-line emitted from a mercury lamp to selectively form exposed portions 5 each of 0.5µm in line width. This exposure process may be achieved with radiation rays such as ultraviolet rays, visible rays, far ultraviolet rays and X-rays, or charged particle beams such as electron beams and ion beams.

To treat the sample with alkali such as ammonia gases, the sample is introduced in a chamber. The chamber is filled with nitrogen at first. Pressure in the chamber is set to 5 Torr, and the temperature of the chamber is maintained at 80 °C - 120 °C, for eample, 90 °C. Then, the ammonia gases are supplied to the chamber. This treatment decomposes carboxylic acid existing in the photosensitive resin layer 2. Instead of exposing the sample to the ammonia gases, the sample may be dipped in solution such as ammonia water.

To obtain a good result from the basic treatment, the treatment shall be carried out at or over 50 °C. After the basic treatment, the inner atmosphere of the chamber is replaced with nitrogen. Then, compounds are applied to the sample such that silylated layers 6b are selectively formed on the exposed portions 5 of the resin layer 2, as shown in Fig. 3(c). The silylated layers are not formed on non-exposed portions 5a of the resin layer 2.

As shown in Fig. 3(d), the non-exposed portions 5a are selectively removed by etching the portions 5a according to a reactive ion etching (RIE) technique, etc. Then, a required negative pattern of 0.5µm in line width is obtained with an SiO₂ layer 7 covering the pattern.

Unlike the conventional patterning method, the method of the invention never forms cracks or cavities on the sample. The reason of this is because the basic treatment makes the exposed portions easily absorb the silicon compounds to increase the density of silicon in the exposed portions, thus improving the degree of hardness of the SiO₂ layer 7.

In reactive-ion-etching the non-exposed portions 5a, a vacuum vessel having parallel plate electrodes is used. The sample is disposed on one of the parallel plate electrodes. Oxygen gases are introduced to the vacuum vessel, and a high-frequency voltage is applied between the electrodes to generate oxygen plasma with which the sample is etched.

### Embodiment 2

Photosensitive material containing naphthoquinone-diazide and polyvinylphenol which is polymer are solved in ethylcellosolveacetate and conditioned to prepare a photosensitive resin layer.

The photosensitive resin layer thus prepared is coated over a silicon wafer in a manner similar to the embodiment 1 and exposed to prepare a sample.

The sample is placed in a nitrogen atmosphere, and imidazole is employed to decompose carboxylic acid existing in the photosensitive resin layer. Then, similar to the embodiment 1, the sample is silylated with hexamethyldisilazane gases, and reactive-ion-etched with oxygen to accurately form a pattern of 0.5µm in line width.

### Embodiment 3

A time of the basic treatment of this embodiment is different from those of the two previous embodiments. A photosensitive resin layer is spin-coated over a silicon wafer and then treated with ammonia to prepare a sample. The sample is exposed, silylated and etched under the same conditions as those of the previous embodiments. Similar to the previous embodiments, this embodiment can provide an accurate pattern. The alkali may be amine such as the following ones: 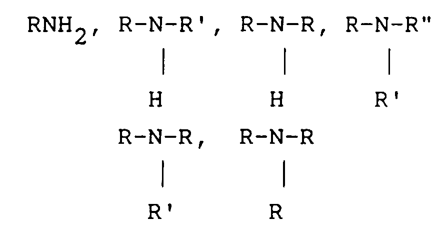 where, R is an alkyl group or aryl group.

Also, the alkali may be imidazole, dimethylamine, trimethylamine, derivatives of them, or mixture of at least two of them.

Polymer of the photosensitive resin layer may be cresol-novolak resin, xylezole-novolak resin, vinylphenol resin, etc.

Patterning accuracy can be improved by increasing etching resistance of the silylated layer. A concrete example of improving the patterning accuracy will be explained with reference to the next embodiment.

### Embodiment 4

A silylated layer is formed according to the processes of the embodiment 1. However, the ammonia treatment is not carried out in the embodiment 4. The embodiment 4 will be explained with reference to Figs. 1(a) to 1(d).

A wafer is placed in a vacuum chamber. Inner pressure of the chamber is set to 0.1 Torr. O₂ gases are injected to the chamber, and gas pressure is set to 1 Torr. A plasma treatment with O₂ is carried out at 500 W for 60 seconds. With this plasma treatment with O₂, a film 7 of SiO₂ structure is formed at least on the surface of each silicon compound layer 6 that has selectively been formed. Instead of treating the wafer with plasma, the wafer may be exposed to a gaseous atmosphere containing oxygen to form a film of SiO₂ structure on the surface of the silicon compound layer 6. However, the plasma treatment is advantageous in obtaining etching resistance.

After that, the wafer is selectively etched according to the reactive ion etching technique with oxygen. The etching is carried out with the conditions of 100 sccm in O₂ flow rate, 6.0 Pa in pressure and 150 W in power to form a desired accurate pattern of 0.5µm in line width. to obtain a more excellent pattern, silicon compounds adhered to non-silylated surface portions may be removed before executing the oxygen plasma treatment.

### Embodiment 5

This is a modification of the embodiment 4. Polyvinylphenol as polymer and photosensitive material containing naphthoquinonediazide are solved in ethyl-cellosolveacetate and coated over a silicon wafer to prepare a sample, similar to the embodiment 4. The sample is exposed and silylated in a nitrogen atmosphere with vaporized hexamethyldisilazane. The sample is subjected to an oxygen plasma treatment at 1.0 Torr and 500 W for 30 seconds. Then, the sample is reactive-ion-etched with oxygen at 100 sccm in flow rate, 6.0 Pa in pressure and 150 W in power. As a result, an accurate pattern of 0.5µm in line width is obtained, similar to the embodiment 4.

The sample may be exposed to a gaseous atmosphere of oxygen, CO₂, NO₂ or SO₂, or to a plasma gaseous atmosphere of oxygen, CO₂, NO₂ or SO₂ to harden the silylated layer.

Although the exposed portions have been silylated to obtain negative patterns in the embodiments mentioned in the above, the non-exposed portions may be silylated to obtain positive patterns.

As described in the above, the hardening treatment with oxygen plasma, etc., carried out in the silylating process can improve selectivity of the exposed and non-exposed portions to provide accurate patterns.

Since a small amount of the silicon compounds are unavoidably absorbed by the non-exposed portions of the resin layer, patterning accuracy may slightly deteriorate. If such absorption of the silicon compounds is not ignorable, the following embodiment is effective to improve the patterning accuracy.

### Embodiment 6

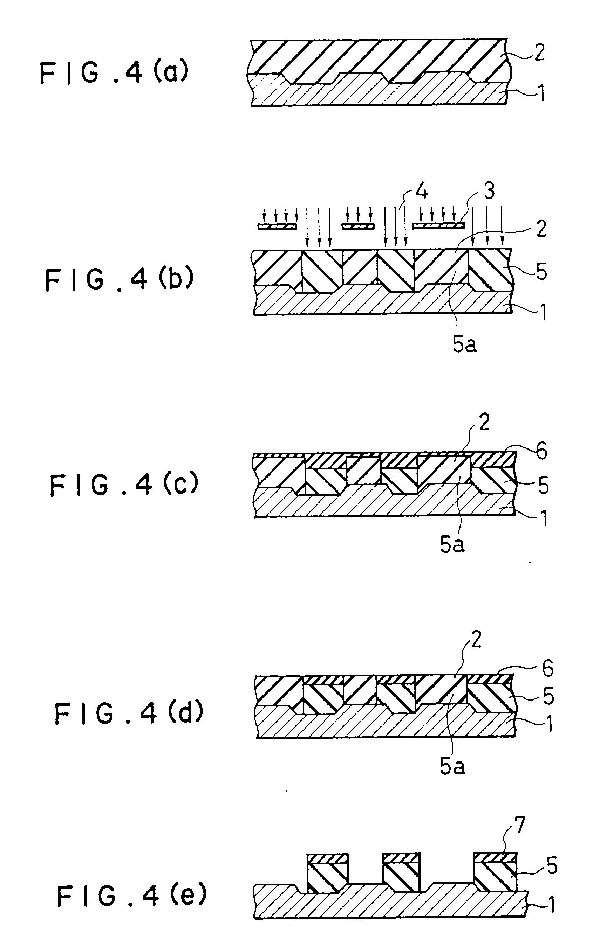

Figures 4(a) to 4(d) are sectional views showing processes of the embodiment 6. Novolak resin and naphthoquinonediazide-sulfonic-acid-ester are mixed at a weight ratio of 4:1 and solved in ethylcellosolve-acetate and conditioned to form a resist layer as a photosensitive resin layer. The resin layer contains polymer mixed with or engaged with photoactive material. A silicon wafer 1 is exposed to an atmosphere of hexamethyldisilazane for 120 seconds to reform the surface of the wafer 1 to improve its adhesion. The previously prepared resist is spin-coated at 3000 rpm over the wafer 1 to form a sample. The sample is baked at 90 °C for five minutes. Masks 3 are disposed on the sample, and the sample is exposed to g-line 4 emitted from a mercury lamp, as shown in Fig. 4(b) to form exposed portions 5 and non-exposed portions 5a.

The sample is placed in a chamber. An inner atmosphere of the chamber is replaced with nitrogen, and inner pressure of the chamber is set to 5 Torr. Vaporized hexamethyldisilazane is injected to the chamber to form silylated regions 6 on the sample, as shown in Fig. 4(c).

To reactive-ion-etch the sample, a vacuum vessel is employed. To vacuum vessel has parallel plate electrodes. The sample is placed on a cathode of the parallel plate electrodes. Argon gases are introduced to the vacuum vessel, and high-frequency electric power of 50 W is applied between the parallel plate electrodes for one minute to etch the silylated sample, as shown in Fig. 4(d).

After that, the sample is subjected to reactive ion etching with oxygen under the conditions of 1 W/cm² and 4.5x10⁻³ Torr. As a result, an accurate resist pattern of 0.5µm in line width is obtained on the silylated exposed portions, as shown in Fig. 4(e).

Although the embodiment has used the rare gas argon, other gases of the group 0 of periodic table may be used to provide the same effect.

The reactive ion etching (RIE) with oxygen carried out after etching the silylated layers with the rare gases may be achieved with a magnetron utilizing a magnetic field. Instead of the RIE, an ECR etching technique may be employed.

Although the embodiment has exposed the sample to a gaseous atmosphere containing silicon to make the photosensitive resin layer absorb silicon compounds, the absorption may be realized by ion implantation.

As described in the above, the silylated portions of the photosensitive resin layer are etched with the rare gases and then dry-etched with oxygen plasma to form a pattern of high selectivity.

### Embodiment 7

This embodiment is materialized by combining several characteristics of the previously explained embodiments. A silylated layer is formed on a photosensitive resin layer according to the processes of the embodiment 1. Due to the ammonia treatment, the silylated layer is formed at high selectivity. Portions of the silylated layer that extend over non-exposed portions of the resin layer are removed by etching them with argon plasma. This etching process is carried out according to the embodiment 6. Portions of the silylated layer extending on exposed portions of the resin layer are hardened by the oxygen plasma treatment of the embodiment 4. After that, the non-exposed portions of the resin layer are removed by the reactive ion etching (RIE) technique. The embodiment 7 improves the effects of the previously explained embodiments.

## Claims

1. A method for forming a mask in a semiconductor substrate comprising:
coating said substrate with a film made of a photosensitive resist comprising a quinonediazide derivative;
partially exposing said film to light in accordance with the pattern of said mask;
applying a silicon compound to said film for silylating said photosensitive resist exposed to light; and removing said exposed photosensitive resist by etching in order to leave said mask,
said method being characterized by
the improvement of the selectivity of silylation in the silicon compound applying step by applying ammonia to said film for decomposing a carboxylic acid occurring in said photosensitive resist, wherein ammonia is applied before the silylating process.

2. The method of claim 1, wherein said silicon compound is hexamethyldisilazane.

3. The method of claim 1 or 2, wherein said photosensitive resist is composed of a polymer.

4. The method of claim 3, wherein said polymer is a polyvinylphenol.

5. The method of claim 1 or 2, wherein said photosensitive resist is composed of novolac resin and a photosensitive material.

6. The method according to any of the preceding claims, wherein said ammonia is applied to said resist at a temperature of no lower than 50°C.

7. The method according to any of the preceding claims, wherein said ammonia is applied to said resist in a chamber at an under atmospheric pressure in which said substrate is heated at a temperature of 50°C to 120°C.

8. The method according to any of the preceding claims, wherein said removing step is carried out by reactive ion etching with oxygen plasma.

9. The method of claim 8, wherein said oxygen plasma is generated by applying high frequency voltage between parallel plate electrodes provided in a vacuum chamber.

10. The method according to any of the preceding claims, wherein said ammonia is applied after the exposing step.

11. The method according to any of the claims 1 to 9, wherein said ammonia is applied before the exposing step.

12. The method according to any of the preceding claims, wherein said ammonia decarbonates said exposed photosensitive resist.

13. The method according to any of the preceding claims, wherein the application of said ammonia suppresses absorption of said silicon compound into the non-exposed photosensitive resist.

14. The method according to any of the preceding claims, wherein said photosensitive resist is exposed to an oxidising atmosphere in order to selectively form a silicon oxide film on the surface of said photosensitive resist film exposed to light.

15. The method of claim 14, wherein said oxidising atmosphere is comprised of a plasma.

16. The method of claim 15, wherein said oxidising plasma is generated from oxygen.

## Patentansprüche

1. Verfahren zum Bilden einer Maske in einem Halbleitersubstrat, welches Verfahren folgendes aufweist:
Überziehen des Substrats mit einem Film, der auf einer photoempfindlichen Schutzschicht aus einem Chinon-Diazid-Derivat hergestellt ist;
teilweises Aussetzen des Films gegenüber Licht gemäß dem Muster der Maske;
Anlegen einer Siliziumverbindung an den Film zum Silizieren der photoempfindlichen Schutzschicht, die dem Licht ausgesetzt wird; und
Entfernen der ausgesetzten photoempfindlichen Schutzschicht durch Ätzen, um die Maske zurückzulassen,
wobei das Verfahren gekennzeichnet ist durch
die Verbesserung der Selektivität der Silizierung im Schritt des Anlegens der Siliziumverbindung durch Anlegen von Ammonium an den Film zum Zerlegen einer Carboxyl-Säure, die in der photoempfindlichen Schutzschicht auftritt, wobei Ammonium vor dem Silizierprozeß angelegt wird.

2. Verfahren nach Anspruch 1, wobei die Siliziumverbindung Hexamethyldisilazan ist.

3. Verfahren nach Anspruch 1 oder 2, wobei die photoempfindliche Schutzschicht aus einem Polymer zusammengesetzt ist.

4. Verfahren nach Anspruch 3, wobei das Polymer ein Polyvinylphenol ist.

5. Verfahren nach Anspruch 1 oder 2, wobei die photoempfindliche Schutzschicht aus Novolak-Kunstharz und einem photoempfindlichen Material zusammengesetzt ist.

6. Verfahren nach einem der vorangehenden Ansprüche, wobei das Ammonium an die Schutzschicht bei einer Temperatur von nicht weniger als 50°C angelegt wird.

7. Verfahren nach einem der vorangehenden Ansprüche, wobei das Ammonium an die Schutzschicht in einer Kammer bei einem Druck unter Atmosphäre angelegt wird, in welcher das Substrat bei einer Temperatur von 50°C bis 120°C erhitzt wird.

8. Verfahren nach einem der vorangehenden Ansprüche, wobei der Entfernungsschritt durch reaktives Ionenätzen mit Sauerstoffplasma ausgeführt wird.

9. Verfahren nach Anspruch 8, wobei das Sauerstoffplasma durch Anlegen einer Hochfrequenzspannung zwischen parallele Plattenelektroden erzeugt wird, die in einer Vakuumkammer vorgesehen sind.

10. Verfahren nach einem der vorangehenden Ansprüche, wobei das Ammonium nach dem Belichtungsschritt angelegt wird.

11. Verfahren nach einem der Ansprüche 1 bis 9, wobei das Ammonium vor dem Belichtungsschritt angelegt wird.

12. Verfahren nach einem der vorangehenden Ansprüche, wobei das Ammonium die belichtete photoempfindliche Schutzschicht decarboniert.

13. Verfahren nach einem der vorangehenden Ansprüche, wobei das Anlegen des Ammoniums eine Absorption der Siliziumverbindung in die nicht belichtete photoempfindliche Schutzschicht unterdrückt.

14. Verfahren nach einem der vorangehenden Ansprüche, wobei die photoempfindliche Schutzschicht einer oxidierenden Atmosphäre ausgesetzt wird, um selektiv einen Siliziumoxidfilm auf der Oberfläche des photoempfindlichen Schutzschichtfilms zu bilden, der Licht ausgesetzt wird.

15. Verfahren nach Anspruch 14, wobei die oxidierende Atmosphäre aus einem Plasma besteht.

16. Verfahren nach Anspruch 15, wobei das oxidierende Plasma aus Sauerstoff erzeugt wird.

## Revendications

1. Procédé de formation d'un masque dans un substrat semi-conducteur comprenant les étapes consistant à :
revêtir ledit substrat avec un film fait d'une réserve photosensible comprenant un dérivé de diazoture de quinone;
exposer partiellement ledit film à de la lumière selon le motif dudit masque;
appliquer un composé de silicium audit film pour silyler ladite réserve photosensible exposée à la lumière; et
enlever ladite réserve photosensible exposée en l'attaquant de manière à laisser ledit masque,
ledit procédé étant caractérisé en ce que la sélectivité de la silylation est améliorée dans l'étape d'application du composé de silicium par application d'ammoniac audit film pour décomposer un acide carboxylique se trouvant dans ladite réserve photosensible, de l'ammoniac étant appliqué avant le procédé de silylation.

2. Procédé selon la revendication 1, dans lequel ledit composé de silicium est l'hexaméthyldisilazane.

3. Procédé selon la revendication 1 ou 2, dans lequel ladite réserve photosensible est composée d'un polymère.

4. Procédé selon la revendication 3, dans lequel ledit polymère est un polyvinylphénol.

5. Procédé selon la revendication 1 ou 2, dans lequel ladite réserve photosensible est composée de résine novolaque et d'un matériau photosensible.

6. Procédé selon l'une quelconque des revendications précédentes, dans lequel on applique ledit ammoniac à ladite réserve à une température pas plus basse que 50°C.

7. Procédé selon l'une quelconque des revendications précédentes, dans lequel on applique ledit ammoniac à ladite réserve dans un compartiment sous une pression inférieure à la pression atmosphérique dans lequel on chauffe ledit substrat à une température de 50°C à 120°C.

8. Procédé selon l'une quelconque des revendications précédentes, dans lequel on effectue l'étape d'enlèvement par attaque à ions réactifs avec un plasma d'oxygène.

9. Procédé selon la revendication 8, dans lequel on produit ledit plasma d'oxygène en appliquant une tension à haute fréquence entre des électrodes plates parallèles se trouvant dans un compartiment sous vide.

10. Procédé selon l'une quelconque des revendications précédentes, dans lequel on applique ledit ammoniac après l'étape d'exposition.

11. Procédé selon l'une quelconque des revendications 1 à 9, dans lequel on applique ledit ammoniac avant l'étape d'exposition.

12. Procédé selon l'une quelconque des revendications précédentes, dans lequel ledit ammoniac décarbonate ladite réserve photosensible exposée.

13. Procédé selon l'une quelconque des revendications précédentes, dans lequel l'application dudit ammoniac supprime l'absorption dudit composé de silicium dans la réserve photosensible non-exposée.

14. Procédé selon l'une quelconque des revendications précédentes, dans lequel on expose ladite réserve photosensible à une atmosphère oxydante pour former sélectivement un film d'oxyde de silicium sur la surface dudit film de réserve photosensible exposé à la lumière.

15. Procédé selon la revendication 14, dans lequel ladite atmosphère oxydante est composée d'un plasma.

16. Procédé selon la revendication 15, dans lequel ledit plasma oxydant est formé à partir d'oxygène.
